# EUROPEAN PATENT SPECIFICATION

(11) **EP 2 015 378 B1**
(45) Date of publication and mention of the grant of the patent: **04.09.2019**
(21) Application number: 08159673.6
(22) Date of filing: 04.07.2008
(51) Int. Cl.: H01L 51/05

(54) **Organic thin-film transistor and method of manufacturing the same**
Organischer Dünnschichttransistor und Herstellungsverfahren
Transistor à couche mince organique et son procédé de fabrication

(30) Priority: 11.07.2007 JP 2007182446; 18.03.2008 JP 2008070379
(43) Date of publication of application: 14.01.2009
(73) Proprietor: Ricoh Company, Ltd., Tokyo 143-8555 (JP)
(72) Inventor: Yamaga, Takumi, Kanagawa (JP); Araumi, Mayuka, Tokyo (JP)
(74) Representative: SSM Sandmair

(56) References cited:
- EP-A- 1 263 062
- WO-A-01/95384
- US-A1- 2007 023 837
- US-A1- 2007 114 524
- US-A1- 2007 134 857

## Description

### BACKGROUND OF THE INVENTION

### 1. Field of the Invention

The present invention relates to an organic thin-film transistor, a method of manufacturing an organic thin-film transistor, an organic thin-film transistor array, a display panel, and a display apparatus.

### 2. Description of the Related Art

Recently, organic thin-film transistors using organic semiconductor materials have been actively studied. The organic thin-film transistors have advantages such a diversity in the composition of materials; high flexibility in their manufacturing method and the type of product; the area size that can be easily increased; simple layer structure and simple production process; and being manufacturable using inexpensive manufacturing equipment.

The organic thin-film transistors may be manufactured using a printing method, a spin-coating method, a dipping method or the like that can easily form thin films and circuits, so that the organic thin-film transistors can be produced at significantly lower cost than the manufacturing cost of thin-film transistors made of Si semiconductor materials. When forming the organic thin-film transistors, an organic semiconductor layer is patterned. If the transistors are formed without patterning the organic semiconductor layer, an off-current is increased when the transistors are in operation, so that power consumption is increased. This may also cause crosstalk when displaying a display medium. For patterning semiconductor layers using Si semiconductor materials, photolithography and etching techniques are used. For instance, patterning is performed by applying photoresist; exposing and developing a desired pattern to form a resist pattern; performing etching using the resist pattern as a mask; and removing the resist.

The organic semiconductor layers may be patterned by using photolithography and etching techniques in the same manner as the semiconductor layers using Si semiconductor materials. In the case where polymeric materials are used as organic semiconductor materials, however, if a pattern is formed by applying photoresist onto a polymeric organic semiconductor layer, transistor properties are highly likely to be reduced. This is because organic solvents (e.g., xylene, cellosolve-based solvents, etc.) in which novolac-based resin having naphthoquinone diazido are dissolved are usually used as a photosensitive material and the polymeric materials are often dissolved in the organic solvents. In the case where crystalline materials such as pentacene are used as organic semiconductor materials, transistor properties can be reduced more or less. Moreover, removers (e.g., ethylene glycol monobutyl ether, monoethanolamine) for removing the resist may cause damage. Rinsing with pure water after removal of the resist may also cause damage.

It is known that a shadow mask may be used when patterning an organic semiconductor layer using a crystalline material such as pentacene. However, such a method has a limitation in the pattern size and is not suitable for patterning a large area. Furthermore, the shadow mask has a limited service life. It is therefore actually difficult to manufacture the organic thin-film transistors at significantly lower cost than the manufacturing cost of the thin-film transistors using Si semiconductor materials.

Meanwhile, inkjet printing is promising as a method for patterning the organic semiconductor layers. Japanese Patent Laid-Open Publication No. 2004-297011 discloses a method of manufacturing an organic thin-film transistor appropriately selecting and using a method that applies charges to a predetermined position of a surface to be coated, applies charges of the opposite polarity to a coating material, and guides the charged material to the predetermined position due to Coulomb's force; a method that forms a recess in a predetermined position on the surface to be coated and applies a coating material such that the coating material is deposited in the recess; and a method that applies a material, forms a pattern by evaporating a solvent, and shapes the pattern using laser irradiation. Japanese Patent Laid-Open Publication No. 2004-141856 discloses a patterning method that forms an indent region in the surface of a substrate and deposits a liquid material in a selected location adjacent to the indent region on the substrate surface.

The inkjet printing methods can directly draw patterns, thereby improving the material usage rate. That is, there is a possibility that patterning the organic semiconductor layers using the inkjet printing methods can achieve simplification of the manufacturing process, improvement in the production yield, and cost reduction.

If a polymeric material soluble in organic solvent is used as an organic semiconductor material, an organic semiconductor ink can be prepared by dissolving the polymeric material in organic solvent, so that an inkjet printing method can be used for patterning. However, it is difficult to form a pattern with a width of 50 µm or less in terms of printing accuracy, and therefore it is difficult to achieve accuracy higher than the accuracy achieved using photomicrography techniques. Reducing the size of ink droplets may be a solution. But, reduction in the droplet size is technically difficult, has stability issues, and easily results in clogged nozzles and ejection of ink droplets at an angle.

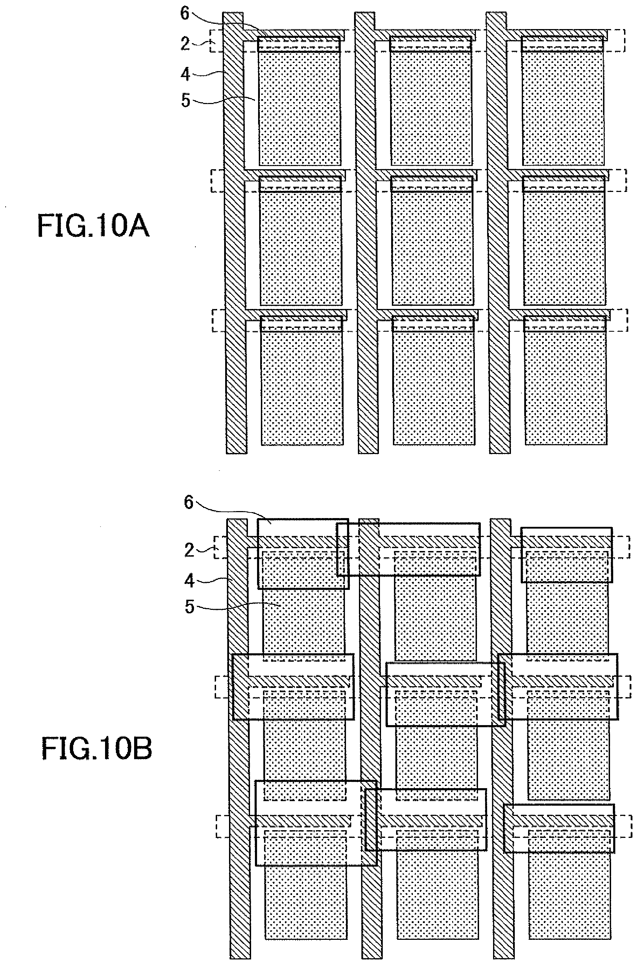

Furthermore, in the case of printing a large area, it is very difficult to accurately pattern all the transistors due to limited ejection accuracy. Especially, because the properties (e.g., viscosity, surface tension, drying properties) of organic semiconductor ink vary depending on the properties (e.g., purity, molecular weight, molecular weight distribution) of the polymeric material to be used and the type of organic solvent, it is difficult to prepare organic semiconductor ink having suitable properties. Therefore, not all the nozzles can always properly eject ink and some of the nozzles may eject ink droplets at an angle or eject varying amounts of ink. The same applies to the head properties. That is, not all the nozzles have the same head properties. If any of the nozzles ejects ink droplets even at a slight angle, it may be possible to form patterns at low resolution but not at high resolution. For example, it is not possible to pattern an organic semiconductor layer in island shapes with high precision as shown in FIG. 10A, and an inaccurate pattern as shown in FIG. 10B is formed. It is to be noted that, in organic thin-film transistor arrays shown in FIGS. 10A and 10B, a gate electrode 2, a gate insulation film (not shown), source and drain electrodes 4 and 5, and an organic semiconductor layer 6 are stacked in this order on a glass substrate (not shown).

### SUMMARY OF THE INVENTION

The scope of the invention is defined in the appended claims. Any reference to "embodiment(s)", "example(s)" or "aspect(s) of the invention" in this description not falling under the scope of the claims should be interpreted as illustrative example(s) for understanding the invention.

In view of the forgoing, the present invention is directed to provide an organic thin-film transistor that allows reduction of off-current and a method of manufacturing the organic thin-film transistor. The present invention is also directed to provide an organic thin-film transistor array having the organic thin-film transistor, a display panel having the organic thin-film transistor array, and a display apparatus having the display panel.

US 2007/023837 A1 discloses a thin film transistor substrate, comprising: an insulating substrate; a source electrode and a drain electrode which are formed on the insulating substrate and separated from each other and have a channel area therebetween; a wall exposing at least portions of the source electrode and the drain electrode, respectively, encompassing the channel area, and formed of fluoropolymer; and an organic semiconductor layer formed inside the wall. Thus, a TFT substrate is provided where an organic semiconductor layer is planarized. Further, a method is provided for a TFT substrate of which an organic semiconductor layer is planarized.

US 2007/114524 A1 discloses a manufacturing method of a display device which includes forming a plurality of gate wires comprising a gate electrode on an insulating substrate, forming an electrode layer comprising a source electrode and a drain electrode spaced apart from each other to define a channel region on the gate electrode interposed therebetween, forming a first barrier wall having a first opening for exposing the channel region, a portion of the source electrode, and a portion of the drain electrode on the electrode layer where the first barrier wall has a surface, forming a shielding film to cover the channel region inside the first opening, treating the surface of the first barrier wall, removing the shielding film, and forming an organic semiconductor layer inside the first opening.

EP 1 263 062 A discloses a sophisticated active matrix type organic semiconductor device.

US 2007/134857 A1 discloses a method of forming an organic thin film transistor. The method includes forming source and drain electrodes on a substrate; forming an insulating layer covering the source and drain electrodes; first surface-treating the insulating layer so that the insulating layer has a hydrophobic surface; forming an opening that exposes facing portions of the source and drain electrodes in the first surface-treated insulating layer; forming an organic semiconductor layer and a gate insulating layer in the opening; second surface-treating the first surface-treated insulating layer so that the insulating layer has a hydrophilic surface; and forming a gate electrode overlapping at least a portion of the source and drain electrodes, an organic thin film transistor, and a flat panel display device including the organic thin film transistor.; According to the method of preparing an organic thin film transistor as described above, at least one of an organic semiconductor layer and a gate insulating layer can be easily formed. When the organic thin film transistor is formed in an array form with respect to a capacitor, the organic thin film transistor has a substantially low parasitic capacitance and the capacitor has a high capacitance.

WO 01/95384 A discloses a method of fabricating an electronic component in which an electrically conductive layer is provided upon a substrate. A mask having a window is provided upon the conductive layer and by etching, preferably chemically, through the window an opening is formed in the conductive layer. Conductive material is deposited, preferably by vapour deposition, through the window to form an island in the opening. The etching of the conductive layer is carried out such that the conductive layer is undercut at the periphery of the window with the result that the periphery of the island is spaced apart from the periphery of the opening. Also disclosed is a thin film transistor structure well suited to fabrication by the above described method.

### SUMMARY OF THE INVENTION

In view of the forgoing, the present invention is directed to provide an organic thin-film transistor in accordance with claim 1. The dependent claims relate to preferred embodiments of the invention.

According an aspect of the present invention, it is possible to provide an organic thin-film transistor that allows reduction of off-current and a method of manufacturing the organic thin-film transistor. According to another aspect of the present invention, it is possible to provide an organic thin-film transistor array having the organic thin-film transistor, a display panel having the organic thin-film transistor array, and a display apparatus having the display panel.

### BRIEF DESCRIPTION OF THE DRAWINGS

FIG. 1 is a cut-away side view showing an example of an organic thin-film transistor array according to an embodiment of the present invention;
FIGS. 2A - 2E are cut-away side views illustrating a method of manufacturing the organic thin-film transistor array of FIG. 1;
FIGS. 3A - 3C are plan views each illustrating the shape of a first portion of an interlayer insulation film;
FIG. 4 is a plan view illustrating the shape of a second portion of the interlayer insulation film;

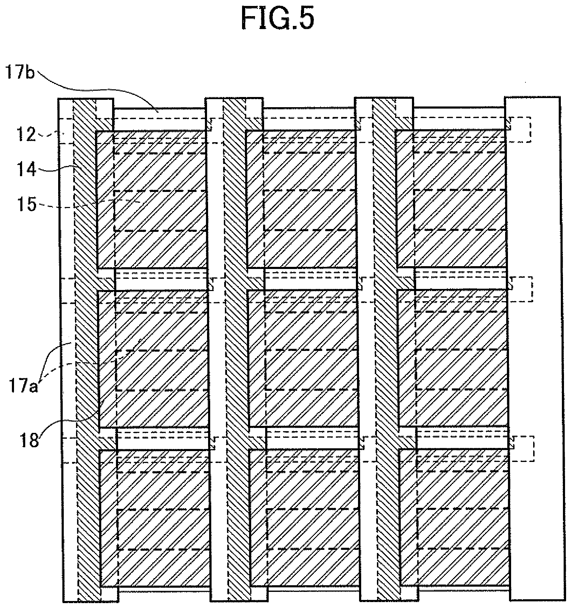

FIG. 5 is a plan view illustrating the shape of a conductive layer;
FIG. 6 is a cut-away side view showing an organic thin-film transistor array of Comparative Example;
FIG. 7 is a cut-away side view showing an organic thin-film transistor array of Example 1;
FIG. 8 is a graph showing on-currents and off-currents of organic thin-film transistors;

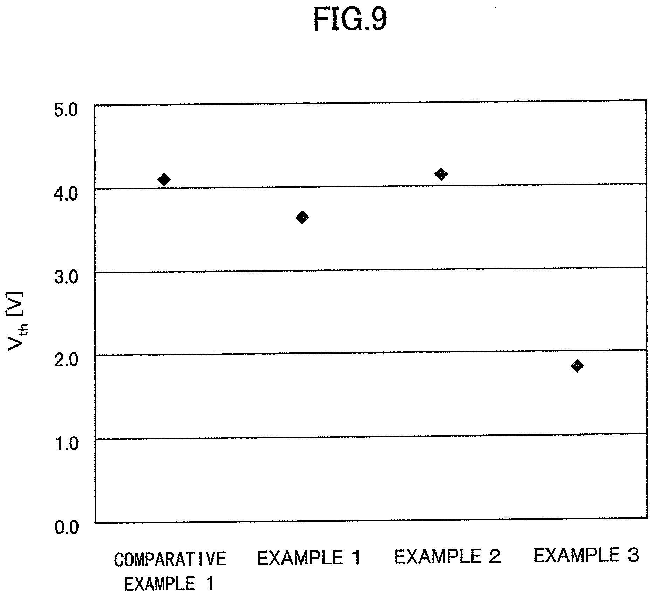

FIG. 9 is a graph showing threshold voltages of organic thin-film transistors;
FIGS. 10A and 10B are plan views each illustrating a related-art organic thin-film transistor;
FIG. 11 is a graph showing the ultraviolet-visible absorption spectrum of a compound represented by Formula (1);
FIG. 12 is a cut-away side view showing an example of a display panel according to an embodiment of the present invention;
FIG. 13 is a perspective view showing an example of a display apparatus according to an embodiment of the present invention;
FIG. 14 is a graph illustrating degradation of transistor properties due to light irradiation;
FIG. 15 is a graph illustrating degradation of transistor properties in a high-humidity test; and
FIG. 16 is a cut-away side view showing a display panel of Embodiment 5.

### DETAILED DESCRIPTION OF THE PREFERRED EMBODIMENT

Preferred embodiments of the present invention are described below with reference to accompanying drawings.

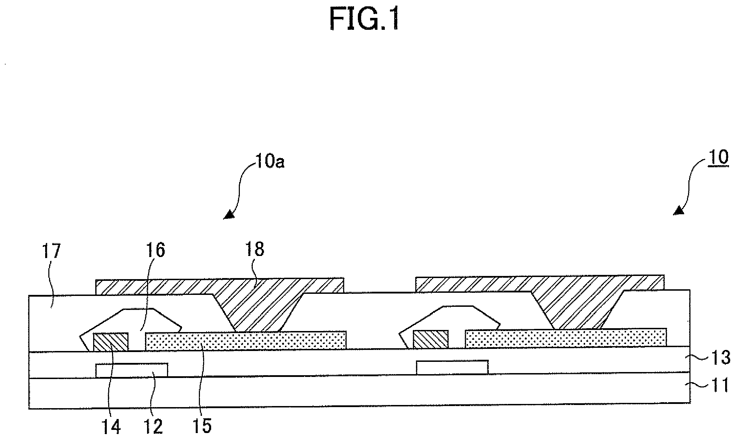

FIG. 1 illustrates an example of an organic thin-film transistor array 10 according to an embodiment of the present invention. The organic thin-film transistor array 10 includes an organic thin-film transistor 10a. In the organic thin-film transistor 10a, a gate electrode 12 is formed on a glass substrate 11, and a gate insulation film 13 is formed on the gate electrode 12. Further, a source electrode 14 and a drain electrode 15 are formed, with a gap therebetween, on the gate insulation film 13. The gap between the source electrode 14 and the drain electrode 15 is formed on the gate electrode 12. An organic semiconductor layer 16 is formed to fill the gap between the source electrode 14 and the drain electrode 15. An interlayer insulation film 17 is formed to cover the organic semiconductor layer 16. A part of the organic semiconductor layer 16 is formed on the interlayer insulation film 17. A conductive layer 18 connected to the drain electrode 15 is formed on the interlayer insulation film 17.

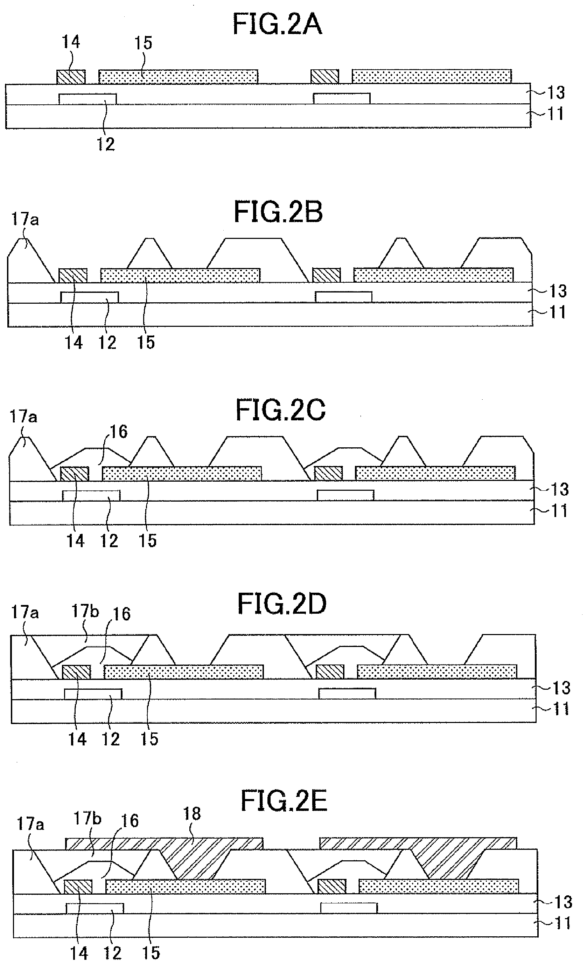

A method of manufacturing the organic thin-film transistor array 10 is described below with reference to FIGS. 2A - 2E. First, the gate electrode 12, the gate insulation film 13, and the source and drain electrodes 14 and 15 are stacked in this order on the glass substrate 11 (see FIG. 2A). Then, first portions 17a of the interlayer insulation film 17 are formed one on each side of the gap between the source electrode 14 and the drain electrode 15 (see FIG. 2B). Then the organic semiconductor layer 16 is formed to fill the gap and be in contact with the first portions 17a of the interlayer insulation film 17 (see FIG. 2C). This improves the patterning accuracy of the organic semiconductor layer 16. The first portions 17a of the interlayer insulation film 17 may partly cover the source electrode 14. Further, the rest (second portion 17b) of the interlayer insulation film 17 is formed on the organic semiconductor layer 16 (see FIG. 2D). Then the conductive layer 18 is formed on the interlayer insulation film 17 so as to be connected to the drain electrode 15 (see FIG. 2E).

The gate electrode 12, the source electrode 14, and the drain electrode 15 may preferably be formed using a printing method such as a screen printing method, an inkjet printing method, a flexographic printing method, a gravure printing method, and an offset printing method. Especially, for forming the source electrode 14 and the drain electrode 15, an inkjet printing method is more preferable in terms of patterning accuracy, cost, and the number of manufacturing steps. Metal ink with metal particles dispersed therein may preferably be used in this process. Examples of metal particles include Au, Ag, Cu, Pt, Pd, Ni, Ir, Rh, Co, Fe, Mn, Cr, Zn, Mo, W, Ru, In, and Sn. These metal particles may be used alone or as a mixture of two or more of them. More preferable are Au, Ag, Cu, and Ni in terms of electric resistance, thermal conductivity, and corrosion resistance.

In the metal ink, metal particles of average particle size ranging from a few nanometers to several tens of nanometers are uniformly dispersed in a solvent. It is possible to sinter such metal particles because metal particles having smaller diameters are more easily affected by atoms at the highly active surface. Therefore, it is possible to print with such a metal ink using an inkjet printing method and sinter the metal particles, thereby directly drawing electrodes. For performing inkjet printing, the metal ink may preferably have a surface tension of about 30 mN/m. The viscosity of the metal ink may preferably be in the range of 2 - 13 mPa·s, more preferably in the range of 7 - 10 mPa·s. A metal ink not having suitable surface tension and viscosity may cause ejection failure or poor performance such as difficulty in forming round droplets, and may also result in ligaments with increased length. The metal ink has drying properties but prevents the metal particles from being solidified due to volatilization of solvent during ejection of the metal ink.

Alternatively, the gate electrode 12, the source electrode 14, and the drain electrode 15 may be formed of conductive polymers. Examples of conductive polymers include polythiophene, polyaniline, polypyrrole, polyparaphenylene, and polyacetylene. These polymers subjected to a doping process may also be used as conductive polymers. A complex (PEDOT/PSS) of polyethylenedioxythiophene (PEDOT) and polystyrenesulfonate(PSS) may be preferable in terms of electric conductivity, stability, heat resistance, etc. The electric properties of the conductive polymers can be adjusted by changing the degree of polymerization and the structure. Furthermore, the conductive polymers can form electrodes at low temperatures because no sintering process is required.

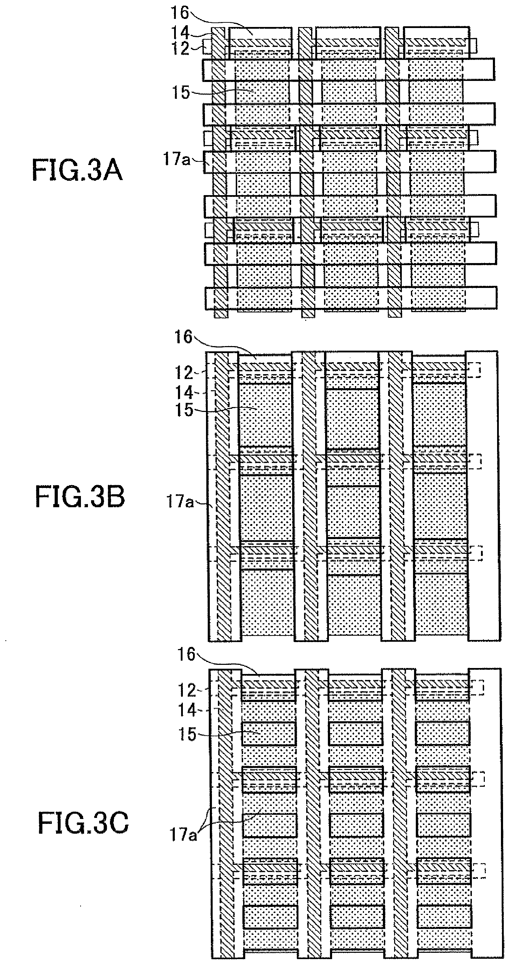

The first portions 17a of the interlayer insulation film 17 formed in the step of FIG. 2B are lines substantially parallel to the channel as shown in FIG. 3A. With this arrangement, the first portions 17a of the interlayer insulation film 17 can prevent, upon forming the organic semiconductor layer 16 using an inkjet printing method, ink from being ejected off the target positions and from spreading on the target surface even if the ink is improperly ejected. As a result, the organic semiconductor layer 16 is formed on the region between the first portions 17a of the interlayer insulation film 17, so that leakage of current via the organic semiconductor layer 16 can be prevented, thereby reducing the off-current and improving the on-off ratio. Moreover, the patterning properties of the organic semiconductor layer 16 are significantly improved, thereby preventing adjacent transistors from adversely affecting each other. The alignment accuracy in forming the organic semiconductor layer 16 is required only in one direction, so that the throughput and production yield can be improved.

In an alternative embodiment, the first portions 17a of the interlayer insulation film 17 may be lines substantially perpendicular to the channel as shown in FIG. 3B. In this case, the first portions 17a of the interlayer insulation film 17 are formed in regions excluding the channel region in the longitudinal direction. With this arrangement, the first portions 17a of the interlayer insulation film 17 prevent, upon forming the organic semiconductor layer 16 using an inkjet printing method, ink from being ejected off the target positions and from spreading on the target surface even if the ink is improperly ejected. As a result, the organic semiconductor layer 16 is formed on the region between the first portions 17a of the interlayer insulation film 17 and therefore can prevent leakage of current via the organic semiconductor layer 16, thereby reducing the off-current and improving the on-off ratio. Moreover, the patterning properties of the organic semiconductor layer 16 are significantly improved, thereby preventing adjacent transistors from adversely affecting each other. The alignment accuracy in forming the organic semiconductor layer 16 is required only in one direction, so that the throughput and production yield can be improved.

In another alternative embodiment, as shown in FIG. 3C, the first portions 17a of the interlayer insulation film 17 formed in the step of FIG. 2B may be a combination of lines substantially parallel to the channel and lines substantially perpendicular to the channel, i.e., may be arranged in a lattice form. With this arrangement, the alignment accuracy in forming the organic semiconductor layer 16 does not need to be high, so that the throughput and production yield can be improved. The first portions 17a of the interlayer insulation film 17 may preferably be formed in a single step, although they may be formed in plural steps. In the case of forming the first portions 17a of the interlayer insulation film 17, after forming first lines, second lines orthogonal to the first lines may be formed. Alternatively, after forming first lines, dots may be formed between the first lines.

The organic semiconductor layer 16 may preferably be formed using a printing method such as a screen printing method, an inkjet printing method, a flexographic printing method, a gravure printing method, and an offset printing method. An inkjet printing method is more preferable in terms of patterning accuracy, cost, and solubility. The organic semiconductor layer 16 may preferably contain an organic semiconductor material soluble in an organic solvent. The organic semiconductor layer 16 can be formed using an organic semiconductor ink having such an organic semiconductor material dissolved in an organic solvent. Non-exclusive examples of organic semiconductor material include polymeric materials, oligomer materials, and low-molecular materials that are soluble in an organic solvent. A polymeric material having a triaryl amine structure is used in the present invention, and a compound represented by the following Formula (1) is preferable.

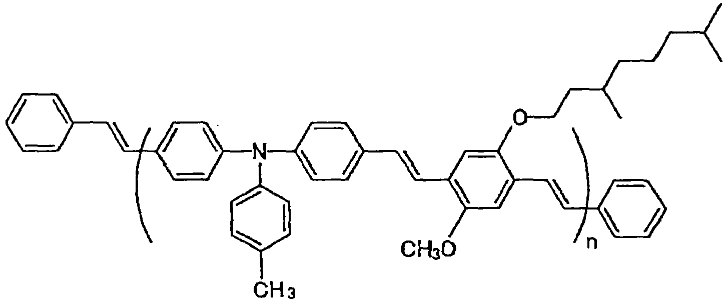

The compound of Formula (1) is a non-oriented polymeric material and its variation in properties is small regardless of the layer shape and the deposition method.

In the case of the related-art transistor array, if the organic semiconductor layer 16 is formed using an inkjet printing method, it is difficult to form a high-precision pattern as shown in FIG. 10A, and an imperfect pattern as shown in FIG. 10B is likely to be formed. Especially, an imperfect pattern is more likely to be formed when patterning a large area. For example, the organic semiconductor layer 16 might be formed not only in the channel region but also in a non-channel region between the source electrode 14 and the drain electrode 15. Furthermore, the organic semiconductor layer 16 might not be divided by organic thin-film transistors of an organic thin-film transistor array so that adjacent organic thin-film transistors adversely affect each other via the organic semiconductor layer 16. The organic semiconductor layer 16 is imperfectly patterned because of influence due to a variation in the head properties, droplets ejected from nozzles at an angle, and the like. It is difficult to make all the nozzles have the same ejection conditions. Moreover, the drying conditions after ejection of droplets differ depending on the shape of the pattern, and the ejected droplets spread differently depending on the drying conditions. If a polymer solution is used as an ink for the organic semiconductor layer 16, a variation in the ejection speed due to changes in the properties may also make it difficult to form a pattern with high precision.

If the pattern of the organic semiconductor layer 16 is imperfect, current leaks via the organic semiconductor layer 16. The leakage of current increases off-current, resulting in reducing the on-off ratio. Furthermore, crosstalk occurs between pixels when displaying an image on a display medium using the organic thin-film transistor array. The influence of the leakage current is notable especially in the case where organic thin-film transistors are densely arranged.

According to the above described embodiment of the present invention, the organic semiconductor layer 16 is formed in contact with the fist portions 17a of the interlayer insulation film 17 and thus can be physically divided by the first portions 17a of the interlayer insulation film 17. Therefore the first portions 17a can block the leakage current, thereby preventing an increase of the off-current.

Generally, the thickness of an organic semiconductor layer formed in island shapes using an inkjet printing method varies greatly due to a coffee stain effect. The coffee stain phenomenon increases the concentration of solute at the edge of a spread droplet after ejection due to evaporation of solvent at the edge of the droplet, and thus makes the thickness greater at the edge and less at the center. The variation in the thickness due to this phenomenon increases the off-current and shifts a threshold voltage Vₜₕ, resulting in increased variation in the transistor properties.

According to this embodiment of the present invention, because the organic semiconductor layer 16 is formed in contact with the first portions 17a of the interlayer insulation film 17, it is possible to prevent the coffee stain phenomenon, thereby improving the uniformity in the thickness of the organic semiconductor layer 16. As a result, it is possible to prevent shifts of the threshold voltage Vₜₕ and reduce the variation in the transistor properties.

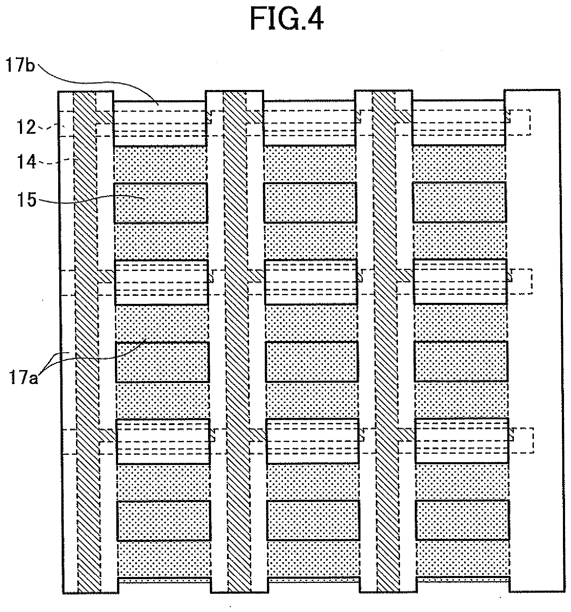

The second portions 17b of the interlayer insulation film 17 are formed on the organic semiconductor layer 16 after forming the first portions 17a shown in FIG. 3C. Thus, the interlayer insulation film 17 having through holes is formed. In the case of the first portions 17a of the interlayer insulation film 17 having the shape shown in FIG. 3A or FIG. 3B, the second portions 17b of the interlayer insulation film 17 are formed in regions on and off the organic semiconductor layer 16, so that an interlayer insulation film 17 similar to the one that is shown in FIG. 4 can be formed.

A printing method such as a screen printing method, an inkjet printing method, a flexographic printing method, a gravure printing method, and an offset printing method may preferably be used for forming the first portions 17a and the second portions 17b of the interlayer insulation film 17, and screen printing is more preferably used. This improves the throughput, reduces the number of manufacturing steps, and reduces costs compared to using a photolithographic technique. The first portions 17a and the second portions 17b of the interlayer insulation film 17 may be formed using the same material or may be formed using different materials.

The interlayer insulation film 17 may preferably contain a binder resin and particles. Examples of binder resin include polyvinyl alcohol resin, polyvinyl acetal resin, acrylic resin, ethyl cellulose resin, polyethylene, polystyrene, and polyamide. These materials may be used alone or as a mixture of two or more of them.

The particles may be any organic or inorganic particles that can exist as particles in the interlayer insulation film 17. However, inorganic particles may be preferable because the inorganic particles are easily controlled in size and are dispersible in solvent. Non-exclusive examples of organic particle include carbon black, azoic pigment, phthalocyanine based pigment, and perylene based pigment. These organic particles may be used alone or as a mixture of two or more of them. Non-exclusive examples of inorganic particles include metal oxide, metal hydroxide, and metal complex such as silica, alumina, titanium oxide, zinc oxide, and barium titanate. These inorganic particles may be used alone or as a mixture of two or more of them. Among these, materials having low permittivity, such as silica, alumina, and zinc oxide may be preferable. The particles may be porous particles, such as mesoporous silica, having mesoporous or porous particles having a microporous structure. To form the interlayer insulation film 17, an insulating paste may be used, which is prepared by mixing a binder resin and particles into a solvent and optionally adding dispersant, plasticizer, and viscosity modifier. The mixture ratio between the binder resin and the particles is not particularly limited and may be appropriately adjusted to make the paste have suitable physical properties in accordance with a pattern to be formed. To ensure flexibility of the interlayer insulation film 17, it is preferable to increase the proportion of the binder resin.

It is commonly known that, absorption of light in organic semiconductor materials causes the transistor properties of an organic thin-film transistor to degrade with time. Therefore, it is preferable that the interlayer insulation film 17 block light absorbable by the organic semiconductor layer 16. The interlayer insulation film 17 may preferably contain a material that can absorb and/or block such light.

The material capable of absorbing the light absorbable by the organic semiconductor layer 16 may be any material that can maintain the insulation properties of the interlayer insulation film 17, such as, but not limited to, metal oxide, metal hydroxide, metal complex, colored particles (carbon black, azoic pigment, phthalocyanine based pigment, perylene based pigment, etc.), and dye (aniline black, indigo, etc.). These materials may be used alone or as a mixture of two or more of them.

The material capable of reflecting the light absorbable by the organic semiconductor layer 16 may be any material that can maintain the insulation properties of the interlayer insulation film 17, such as, but not limited to, white pigments including titanium oxide and zinc oxide. These materials may be used alone or as a mixture of two or more of them.

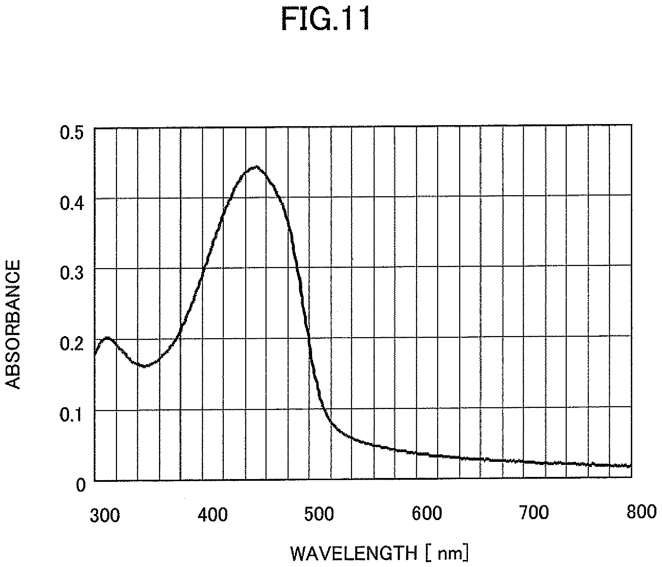

The compound of Formula (1) as an example of the organic semiconductor material is described below. FIG. 11 is a graph showing the ultraviolet-visible absorption spectrum of a 40 nm thick film of a compound represented by Formula (1). The graph of FIG. 11 indicates that the compound of Formula (1) tends to absorb light of 600 nm wavelength or less. Likewise, triaryl polymeric materials having a amine structure absorb light of 600 nm wavelength or less. Therefore, in the case where a polymeric material having a triaryl amine structure is used as the organic semiconductor material, the interlayer insulation film 17 is preferably capable of blocking light of 600 nm wavelength or less. Such an interlayer insulation film 17 can prevent the transistor properties of the organic thin-film transistor array 10 from degrading over time.

It is also commonly known that oxidation of organic semiconductor materials by oxygen in the air and water adsorption in organic semiconductor materials degrade transistor properties of an organic thin-film transistor with time. Therefore, it is preferable that the interlayer insulation film 17 block oxygen and moisture. The oxygen transmission rate and water vapor transmission rate of the interlayer insulation film 17 may be suitably selected depending on the polymeric material having a triaryl amine structure of the organic semiconductor layer 16. For example, the oxygen transmission rate and the water vapor transmission rate of an organic EL panel having the organic thin-film transistor array 10 are preferably less than 10⁻² cc/m²/day/atm/0.1 mm and less than 10⁻⁵ g/m²/day/atm/0.1 mm, respectively. Such an organic EL panel can prevent degradation of its properties over time. If the organic semiconductor layer 16 is formed of a highly weather-resistant polymeric material having a triaryl amine structure, the upper limits of the oxygen transmission rate and the water vapor transmission rate of the organic EL panel can be increased.

The interlayer insulation film 17 as described above can also prevent the properties of the organic thin-film transistor array 10 from degrading due to photoinduced oxidation.

The interlayer insulation film 17 may preferably contain a material soluble in a solvent that does not dissolve or swell the organic semiconductor layer 16. This prevents degradation of the organic semiconductor layer 16 during formation of the interlayer insulation film 17.

Non-exclusive examples of solvent that does not dissolve or swell the organic semiconductor layer 16 formed of a polymeric triaryl material having a amine structure include ethylene glycol butyl ether, ethylene glycol hexyl ether, dipropylene glycol butyl ether, dipropylene glycol methyl ether acetate, tripropylene glycol methyl ether, diethylene glycol butyl ether, α-terpineol, ethylene alcohol, isopropyl alcohol, 2,2,4-trimethyl-1, and 3-pentanediol monoisobutylate. These materials may be used alone or as a mixture of two or more of them.

Examples of binder resin of the interlayer insulation film 17 that are soluble in these solvents include polyvinyl alcohol resin, polyvinyl acetal resin, acrylic resin, ethyl cellulose resin, polyethylene, polystyrene, and polyamide. Theses materials may be used alone or as a mixture of two or more of them.

After forming the second portions 17b of the interlayer insulation film 17 shown in FIG. 4, the conductive layer 18 is formed in and over the through hole and on the interlayer insulation film 17 so as to be connected to the drain electrode 15. The conductive layer 18 may be formed by patterning a thermocuring paste containing silver using a screen printing method.

In the manner as described above, an organic thin-film transistor array of an embodiment of the present invention can be manufactured with a reduced number of manufacturing steps and at low cost.

Display panels such as electrophoresis panels, liquid crystal panels, and organic EL panels may be formed by combining an organic thin-film transistor array of an embodiment of the present invention, which is used as an active matrix substrate, and display devices such as electrophoresis display devices, liquid crystal display devices, and organic EL display devices.

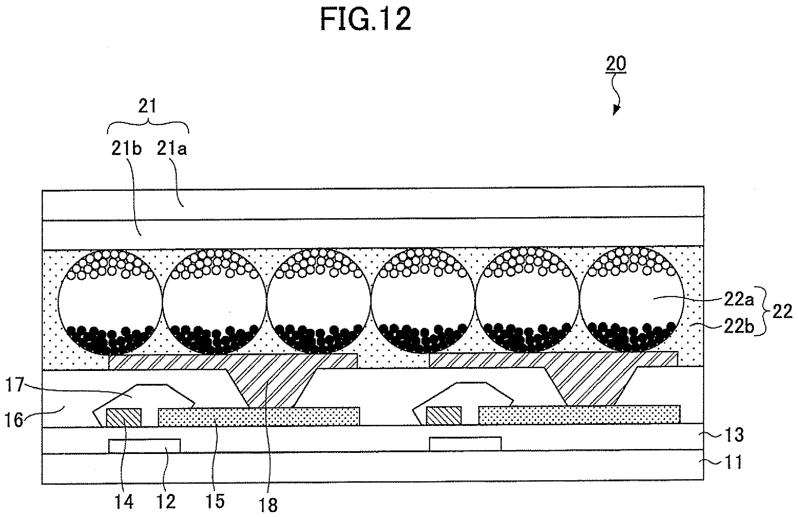

FIG. 12 illustrates an electrophoresis panel 20 as an example of a display panel according to an embodiment of the present invention. A method of manufacturing the display panel 20 is described below. First, as shown in FIG. 12, a gate electrode (scanning line) 12 is formed on a film substrate (or a thin-film SUS substrate) 11 by inkjet printing using an Ag ink having Ag particles dispersed therein. Then, polyamide acid is applied onto the gate electrode 12 using a spin coating method and is heated, thereby forming a gate insulation film 13. Then, ultraviolet rays are irradiated onto the gate insulation film 13 through a photomask, thereby forming a high energy pattern on the surface. Then, a source electrode (signal line) 14 and a drain electrode 15 are formed on the high energy pattern by inkjet printing using an Ag ink having Ag particles dispersed therein. First portions 17a of an interlayer insulation film 17 are formed by screen printing using an insulation paste. An organic semiconductor layer 16 is formed in contact with the first portions 17a of the interlayer insulation film 17 by screen printing using an organic semiconductor ink. Second portions 17b of the interlayer insulation film 17 are formed on the organic semiconductor layer 16 by screen printing using an insulation paste. A conductive layer 18 is formed so as to be connected to the drain electrode 15 by screen printing using a conductive paste. An organic thin-film transistor array 10 can be formed with the steps described above.

A transparent conductive film 21b of ITO (Indium Tin Oxide) is formed on a film substrate 21a by sputtering, thereby forming a transparent conductive coated film substrate 21.

A mixture of titanium oxide, silicone macromer/methacrylic acid copolymer, silicone polymer graft carbon black, and silicone oil is dispersed by ultrasonic waves to obtain a dispersion liquid of black and white particles. Microcapsules 22a are formed from the dispersion liquid of black and white particles by a complex coacervation method using gelatin and Arabic gum. The microcapsules 22a are dispersed in a solution of urethane resin 22b to obtain a dispersion liquid. The dispersion liquid is spread onto the transparent conductive coated film substrate 21 to form electrophoresis devices 22. The electrophoresis devices 22 are connected to the conductive layer 18 of the organic thin-film transistor array 10, so that the electrophoresis panel 20 having memory properties and flexibility can be formed.

A liquid crystal panel can be formed by connecting an organic thin-film transistor array of an embodiment of the present invention to a transparent conductive coated substrate with a silica spacer interposed therebetween, and filling the gap with a liquid crystal material. The transparent conductive coated substrate used herein has an alignment film subjected to a rubbing process.

An organic EL panel can be formed by forming an organic EL device in an organic thin-film transistor array of an embodiment of the present invention and disposing an atmospheric shield.

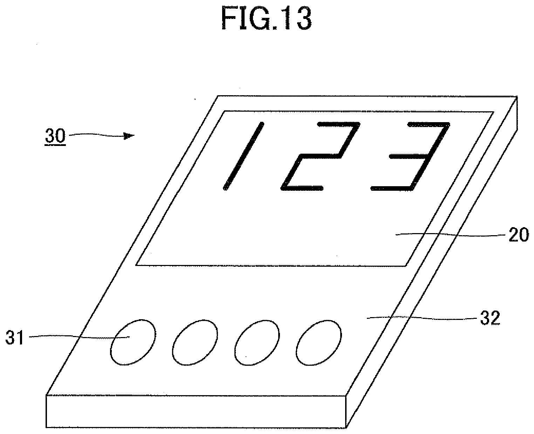

FIG. 13 shows an example of a display apparatus 30 according to an embodiment of the present invention. The display apparatus 30 includes an electrophoresis panel 20, an information input unit 31 configured to input information of an image to be displayed to the electrophoresis panel 20, a casing 32, a drive circuit (not shown), an arithmetic circuit (not shown), an internal memory (not shown), and a power supply unit (not shown) configured to supply power to the electrophoresis panel 20 and the information input unit 31. A gate electrode (scanning line) 12 and a source electrode (signal line) 14 of the electrophoresis panel 20 form a dot matrix, and turn on the specified dots to display an image as a whole. The power supply unit may be an internal power supply such as a battery or may be a power receiving unit such as a socket for receiving power from an external power supply.

The display apparatus of an embodiment of the present invention may be any apparatus that includes a display panel of an embodiment of the present invention and a unit that supplies power to the display panel, and may include, but is not limited to, portable terminals such as PDAs and electronic book terminals.

### <Examples>

The preferred embodiments of the present invention are described in greater detail with reference to specific examples, although the present invention is not limited to these examples.

### (Comparative Example 1)

Polyamide acid was applied onto a glass substrate 11 by spin coating and was heated at 280 ° C to form an insulation film 19 of 200 nm thickness. Then, ultraviolet rays were irradiated through a photomask using a UV lamp (irradiation volume: 7 J/cm²) to form a high energy pattern on the surface. Then, an Ag ink having Ag particles dispersed therein was ejected onto the high energy pattern using an inkjet printing method and was sintered at 280 °C to form a gate electrode 12 of 100 nm thickness. Polyamide acid was applied onto the gate electrode 12 by spin coating and was heated at 280 °C to form a gate insulation film 13 of 500 nm thickness. Then, ultraviolet rays were irradiated through a photomask using a UV lamp (irradiation volume: 7 J/cm²) to form a high energy pattern on the surface. Then, an Ag ink was ejected onto the high energy pattern using an inkjet printing method and was sintered at 280 °C to form a source electrode 14 and a drain electrode 15 of 100 nm thickness. The channel width was 140 µm and the channel length was 10 µm.

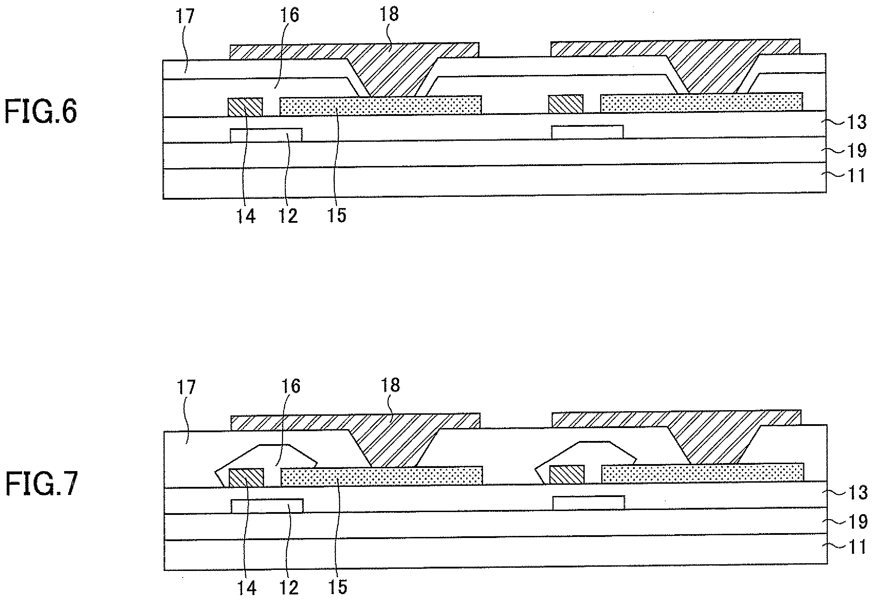

An organic semiconductor ink having a compound of Formula (1) dissolved in tetralin was applied using an inkjet printing method to form an island-shaped organic semiconductor layer 16 (see FIG. 10B). Then an insulation paste containing polyvinyl butyral resin, a silica filler, and ethylene glycol hexyl ether was printed using a screen printing method and was dried to form an interlayer insulation film 17 that covers the organic semiconductor layer 16. Then a thermocuring paste containing silver was printed using a screen printing method and was dried to form a conductive layer 18 connected to the drain electrode 15. Thus an organic thin-film transistor array was obtained (see FIG. 6).

### (Example 1)

Polyamide acid was applied onto a glass substrate 11 by spin coating and was heated at 280 °C to form an insulation film 19 of 200 nm thickness. Then, ultraviolet rays were irradiated through a photomask using a UV lamp (irradiation volume 7 J/cm²), thereby forming a high energy pattern on the surface. Then, an Ag ink having Ag particles dispersed therein was ejected onto the high energy pattern using an inkjet printing method and was sintered at 280 °C to form a gate electrode 12 of 100 nm thickness. Polyamide acid was applied onto the gate electrode 12 by spin coating and was heated at 280 °C to form a gate insulation film 13 of 500 nm thickness. Then, ultraviolet rays were irradiated through a photomask using a UV lamp (irradiation volume: 7 J/cm²) to form a high energy pattern on the surface. Then, an Ag ink was ejected onto the high energy pattern using an inkjet printing method and was sintered at 280 °C to form a source electrode 14 and a drain electrode 15 of 100 nm thickness. The channel width was 140 µm and the channel length was 10 µm.

Then an insulation paste containing polyvinyl butyral resin, a silica filler, and ethylene glycol hexyl ether was printed using a screen printing method and was dried to form first portions 17a of an interlayer insulation film 17 to be lines parallel to the channel (see FIG. 2B and FIG. 3A). An organic semiconductor ink having a compound of Formula (1) dispersed in tetralin was applied using an inkjet printing method to form an organic semiconductor layer 16 in contact with the first portions 17a of the interlayer insulation film 17. Then the same insulation paste as the insulation paste of the first portions 17a of the interlayer insulation film 17 was printed using a screen printing method to form second portions 17b of the interlayer insulation film 17 on the organic semiconductor layer 16. The interlayer insulation film 17 had an oxygen transmission rate of 600 cc/m²/day/atm/0.1 mm and a water vapor transmission rate of 50 g/m²/day/atm/ 0.1 mm. Then a thermocuring paste containing silver was printed using a screen printing method and was dried to form a conductive layer 18 connected to the drain electrode 15. Thus an organic thin-film transistor array was obtained (see FIG. 7).

### (Example 2)

An organic thin-film transistor array was obtained in the same manner as Example 1 except that the first portions 17a of the interlayer insulation film 17 were formed as lines perpendicular to the channel (see FIG. 3B).

### (Example 3)

An organic thin-film transistor array was obtained in the same manner as Example 1 except that the first portions 17a of the interlayer insulation film 17 were formed as lines parallel to and perpendicular to the channel, i.e., in a lattice form (see FIG. 2B and FIG. 3C).

### (Evaluation of transistor properties)

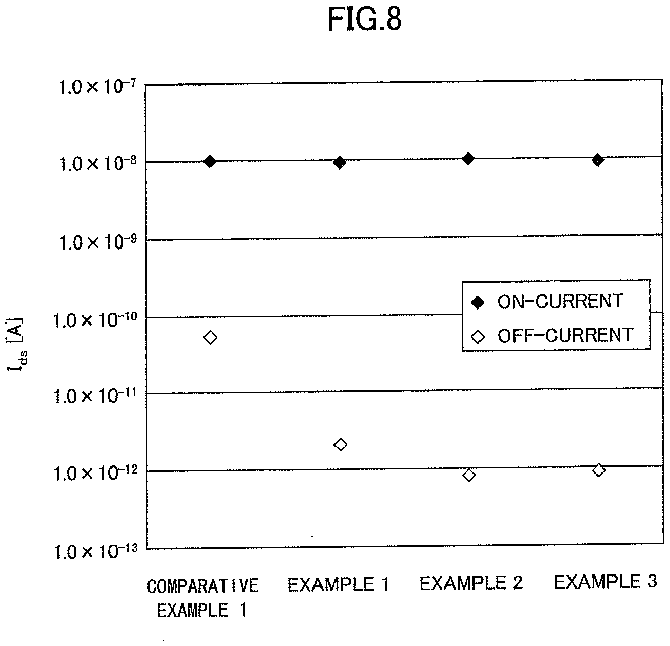

The transistor properties of the obtained organic thin-film transistor arrays were measured in an atmosphere containing less than 1 ppm oxygen and less than 1 ppm moisture. The drain voltage V_{ds} was -20 V and the gate voltage V_{g} was scanned from +20 V to -20 V. The graph of FIG. 8 shows the measurement results of the drain currents I_{ds} (on-currents) flowed when V_{g} was -20 V and the drain currents I_{ds} (off-currents) when V_{g} was +20 V. More specifically, the on-currents of Comparative Example 1 and Examples 1 - 3 were -1.0×10⁻⁸ A, -9.0×10⁻⁹ A. - 1.0×10⁻⁸ A, and -9.0×10⁻⁹ A, respectively. The off-currents of Comparative Example 1 and Examples 1 - 3 were -5.4×10⁻¹¹ A, -2.1×10⁻¹² A, - 8.0×10⁻¹³ A, and -9.0×10⁻¹³ A, respectively. The threshold voltages Vₜₕ of Comparative Example 1 and Examples 1 - 3 were 4.11 V, 3.63 V, 4.13 V, and 1.82 V, respectively.

The organic thin-film transistors of Examples 1 and 2 had the off-currents lower than the off-current of the organic thin-film transistor of Comparative Example 1 and therefore had improved on-off ratios. This suggests that the organic thin-film transistors of Examples 1 and 2 have better transistor properties. The organic thin-film transistor of Example 3 had Vₜₕ lower than Vₜₕ of Examples 1 and 2. This suggests that the organic thin-film transistor of Example 3 has further better transistor properties.

### (Evaluation of degradation of transistor properties due to light irradiation)

Light was irradiated onto the organic thin-film transistor array of Example 3 using a light source with an illuminance of 100000 lux while blocking light beams of 600 nm wavelength or less, light beams of 500 nm wavelength or less, and light beams of 450 nm wavelength or less using filters, thereby obtaining Samples A, B, and C, respectively. Then the mobility of Samples A, B, and C was measured. The mobility was measured with the drain voltage V_{ds} of -20 V and the gate voltage V_{g} varying from +20 V to -20 V.

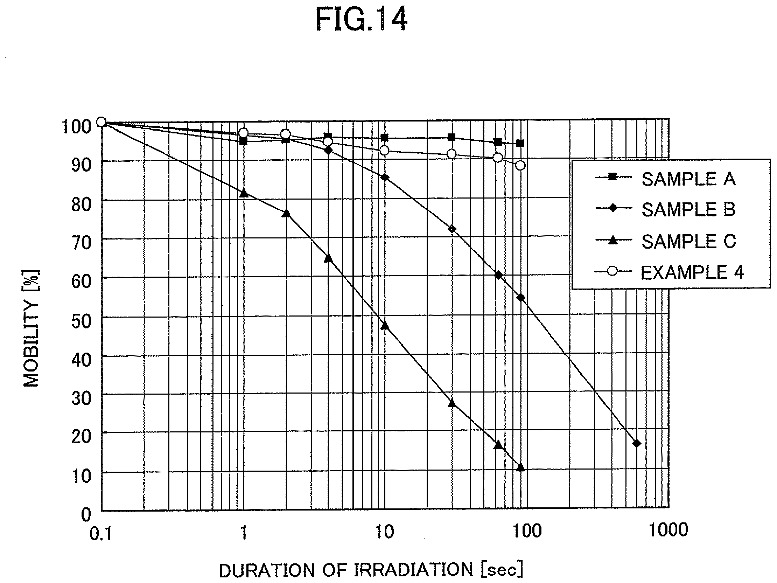

FIG. 14 shows the evaluation result. The mobility of the organic thin-film transistor array before irradiation of light was 100%. In FIG. 14, the mobility of Samples B and C decreased as the duration of irradiation increased. On the other hand, the transistor properties of Sample A did not significantly decrease with the increase of duration of irradiation.

### (Example 4)

An organic thin-film transistor array was obtained in the same manner as Example 4 except that an insulation paste containing polyvinyl butyral resin, a silica filler, aniline black, and ethylene glycol hexyl ether was used for forming the interlayer insulation film 17.

### (Evaluation of degradation of transistor properties due to light irradiation)

Light having wavelength in a range of 300 - 1400 nm was irradiated onto the organic thin-film transistor array of Example 4 using a light source with an illuminance of 100,000 lux. Then the mobility of the organic thin-film transistor array of Example 4 was measured. The mobility was measured with the drain voltage V_{ds} of -20 V and the gate voltage V_{g} varying from +20 V to -20 V.

FIG. 14 shows the evaluation result. The mobility of the organic thin-film transistor array before irradiation of light was 100%. Similar to Sample A, the transistor properties of the organic thin-film transistor array of Example 4 did not significantly decrease with the increase of duration of irradiation.

### (Comparative Example 2)

An organic thin-film transistor array was obtained in the same manner as Example 3 except that the second portions 17b were not formed on the organic semiconductor layer 16.

### (Evaluation of degradation of transistor properties in a high-humidity test)

A high-humidity test was performed on the organic thin-film transistor arrays of Example 3 and Comparative Example 2 in a 25 °C, 85% RH environment. Then the mobility was measured in the atmosphere. The mobility was measured with the drain voltage V_{ds} of -20 V and the gate voltage V_{g} varying from +20 V to -20 V.

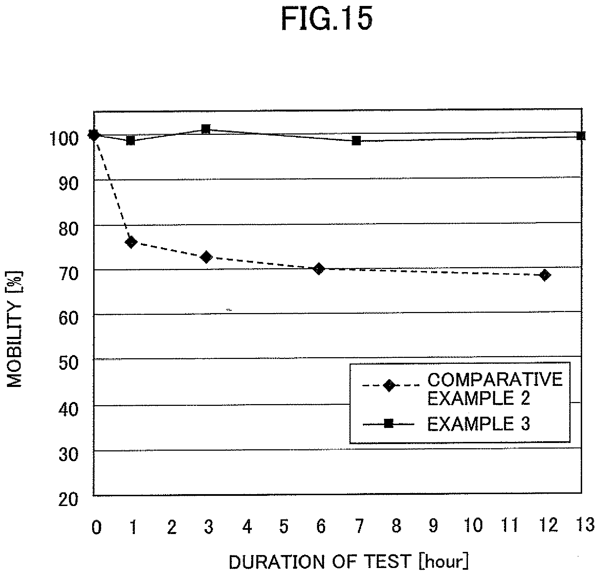

FIG. 15 shows the evaluation result. The mobility of the organic thin-film transistor array before the high-humidity test was 100%. In FIG. 15, the mobility of the organic thin-film transistor array of Comparative Example 2 decreased as the duration of the test increased. On the other hand, the organic thin-film transistor array of Example 3 maintained the transistor properties regardless of the increase of duration of the test.

### (Example 5)

A transparent conductive film 21b of ITO (Indium Tin Oxide) was formed on a film substrate 21a by sputtering, thereby forming a transparent conductive coated film substrate 21.

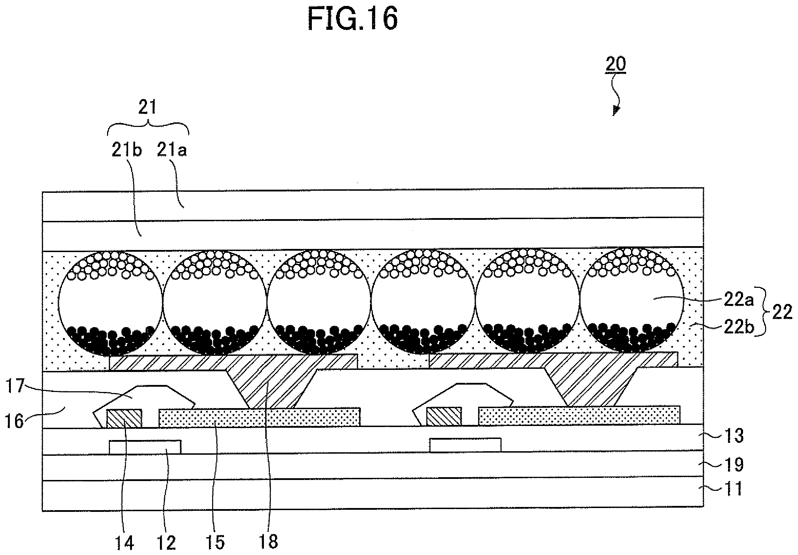

Twenty parts by weight of titanium oxide, 1 part by weight of silicone macromer/methacrylic acid copolymer, 2 parts by weight of silicone polymer graft carbon black, and 77 parts by weight of silicone oil were mixed and dispersed for 1 hour by ultrasonic waves to obtain a dispersion liquid of black and white particles. Microcapsules 22a were formed from the dispersion liquid of black and white particles by a complex coacervation method using gelatin and Arabic gum. The average particle diameter of the microcapsules 22a was about 60 µm. The microcapsules 22a were dispersed in a solution of urethane resin 22b to obtain a dispersion liquid. The dispersion liquid was spread onto the transparent conductive coated film substrate 21 to form electrophoresis devices 22. The electrophoresis devices 22 were connected to the conductive layer 18 of the organic thin-film transistor array 10 of Example 1, so that an electrophoresis panel was obtained (see FIG. 16).

## Claims

1. An organic thin-film transistor (10), comprising:
a gate electrode (12) formed on a substrate (11);
a gate insulation film (13) formed on the gate electrode (12);
a source electrode (14) and a drain electrode (15) formed, with a gap therebetween, at least over the gate electrode (12) on which the gate insulation film (13) is formed;
an organic semiconductor layer (16) formed in a region including the gap;
an interlayer insulation film (17) having a first portion (17a) formed to be partly covered by a part of the organic semiconductor layer (16) and having a second portion (17b) formed to cover the organic semiconductor layer (16); and
a conductive layer (18) formed on the interlayer insulation film (17) and connected to the drain electrode (15);
**characterized in that**
the organic semiconductor layer (16) comprises an organic semiconductor material soluble in an organic solvent, said organic semiconductor layer (16) being a polymeric material having a triaryl amine structure.

2. The organic thin-film transistor (10) as claimed in claim 1, **characterized in that** the interlayer insulation film (17) contains a binder resin and particles.

3. The organic thin-film transistor (10) as claimed in any one of claims 1 or 2, **characterized in that** the interlayer insulation film (17) includes a material which comprises at least one of metal oxide, metal hydroxide, metal complex, colored particles - in particular carbon black, azoic pigment, phthalocyanine based pigment, perylene based pigment and dye - in particular aniline black, indigo and white pigments including titanium oxide and zinc oxide such that the interlayer insulation layer is capable of blocking light of 600 nm or less.

4. The organic thin-film transistor (10) as claimed in claim 3, **characterized in that** the organic semiconductor layer (16) absorbs light with a wavelength of 600 nm or less.

5. The organic thin-film transistor (10) as claimed in any one of claims 1 and 2 through 4, **characterized in that** the interlayer insulation film (17) includes a material which comprises at least one of metal oxide, metal hydroxide, metal complex, colored particles - in particular carbon black, azoic pigment, phthalocyanine based pigment, perylene based pigment and dye - in particular aniline black, indigo and white pigments including titanium oxide and zinc oxide and has an oxygen transmission rate of less than 10⁻² cc/m²/day/atm/0.1 mm and a water vapor transmission rate of less than 10⁻⁵ g/m²/day/atm/0.1 mm.

6. The organic thin-film transistor (10) as claimed in any one of claims 1 and 2 through 5, **characterized in that** the interlayer insulation film (17) contains at least one of polyvinyl alcohol resin, polyvinyl acetal resin, acrylic resin, ethyl cellulose resin, polyethylene, polystyrene, polyamide soluble in at least one of ethylene glycol butyl ether, ethylene glycol hexyl ether, dipropylene glycol butyl ether, dipropylene glycol methyl ether acetate, tripropylene glycol methyl ether, diethylene glycol butyl ether, α-terpineol, ethylene alcohol, isopropyl alcohol, 2,2,4-trimethyl-1 and 3-pentanediol monoisobutylate such that the solvent does not dissolve or swell the organic semiconductor layer.

7. A method of manufacturing the organic thin-film transistor (10) of any one of claims 1 through 6, the method **characterized by**:
a step of forming the gate electrode (12) on the substrate (11);
a step of forming the gate insulation film (13) on the gate electrode (12);
a step of forming the source electrode (14) and the drain electrode (15), with the gap therebetween, at least over the gate electrode (12) on which the gate insulation film (13) is formed;
a step of forming a first portion (17a) of the interlayer insulation film (17) on the substrate (11) on which the source electrode (14) and the drain electrode (15) are formed;
a step of forming the organic semiconductor layer (16) in contact with the first portion (17a) of the interlayer insulation film (17) in a region including the gap; and
a step of forming a second portion (17b) of the interlayer insulation film (17) at least over the organic semiconductor layer (16),
**characterized in that** the organic semiconductor layer (16) comprises and organic semiconductor material soluble in an organic solvent is a polymeric material having a triaryl amine structure.

8. The method of manufacturing the organic thin-film transistor (10) as claimed in claim 7, **characterized in that** the first portion (17a) of the interlayer insulation film (17) is formed in a lattice shape or in a shape of lines.

9. The method of manufacturing the organic film-thin transistor (10) as claimed in claim 7, **characterized in that** forming the organic semiconductor layer (16) comprises printing of the organic semiconductor layer (16).

10. The method of manufacturing the organic film-thin transistor (10) as claimed in claim 7 **characterized in that** forming the organic semiconductor layer (16) comprises inkjet printing of the organic semiconductor layer (16).

11. The method of manufacturing the organic film-thin transistor (10) as claimed in claim 7, **characterized in that** forming the first (17a) and second (17b) portions of the interlayer insulation films (17) comprises printing of the interlayer insulation film (17).

12. The method of manufacturing the organic film-thin transistor (10) as claimed in claim 7, **characterized in that** forming the first (17a) and second (17b) portions of the interlayer insulation film (17) comprises screen printing of the interlayer insulation film (17).

13. An organic thin-film transistor array, **characterized by**:
the organic thin-film transistor (10) of any one of claims 1 through 6.

## Patentansprüche

1. Organischer Dünnfilmtransistor (10), umfassend:
eine Gate-Elektrode (12), die auf einem Substrat (11) gebildet ist;
einen Gate-Isolierfilm (13), der auf der Gate-Elektrode (12) gebildet ist;
eine Source-Elektrode (14) und eine Drain-Elektrode (15), die mit einem Spalt dazwischen mindestens über der Gate-Elektrode (12) gebildet sind, auf der der Gate-Isolierfilm (13) gebildet ist;
eine organische Halbleiterschicht (16), die in einem Bereich gebildet ist, der den Spalt enthält;
einen Zwischenschichtisolierfilm (17) mit einem ersten Abschnitt (17a), der gebildet ist, um teilweise von einem Teil der organischen Halbleiterschicht (16) abgedeckt zu sein, und mit einem zweiten Abschnitt (17b), der gebildet ist, um die organische Halbleiterschicht (16) abzudecken; und
eine leitfähige Schicht (18), die auf dem Zwischenschichtisolierfilm (17) gebildet und mit der Drain-Elektrode (15) verbunden ist;
**dadurch gekennzeichnet, dass**
die organische Halbleiterschicht (16) ein organisches Halbleitermaterial umfasst, das in einem organischen Lösungsmittel löslich ist, wobei die organische Halbleiterschicht (16) ein polymeres Material mit einer Triarylamin-Struktur ist.

2. Organischer Dünnfilmtransistor (10) nach Anspruch 1, **dadurch gekennzeichnet, dass** der Zwischenschichtisolierfilm (17) ein Bindemittelharz und Partikel enthält.

3. Organischer Dünnfilmtransistor (10) nach einem der Ansprüche 1 oder 2, **dadurch gekennzeichnet, dass** der Zwischenschichtisolierfilm (17) ein Material enthält, das mindestens eines von Metalloxid, Metallhydroxid, Metallkomplex, gefärbten Partikeln - insbesondere Ruß, Azopigment, Phthalocyanin-basiertes Pigment, Perylen-basiertes Pigment und Farbstoff - insbesondere Anilinschwarz, Indigo und Weißpigmente, einschließlich Titanoxid und Zinkoxid umfasst, sodass die Zwischenschichtisolierschicht in der Lage ist, Licht von 600 nm oder weniger zu blockieren.

4. Organischer Dünnfilmtransistor (10) nach Anspruch 3, **dadurch gekennzeichnet, dass** die organische Halbleiterschicht (16) Licht mit einer Wellenlänge von 600 nm oder weniger absorbiert.

5. Organischer Dünnfilmtransistor (10) nach einem der Ansprüche 1 und 2 bis 4, **dadurch gekennzeichnet, dass** der Zwischenschichtisolierfilm (17) ein Material enthält, das mindestens eines von Metalloxid, Metallhydroxid, Metallkomplex, gefärbten Partikeln - insbesondere Ruß, Azopigment, Phthalocyanin-basiertes Pigment, Perylen-basiertes Pigment und Farbstoff - insbesondere Anilinschwarz, Indigo und Weißpigmente, einschließlich Titanoxid und Zinkoxid umfasst und eine Sauerstoffübertragungsrate von weniger als 10⁻² cm³/m²/Tag/atm/0,1 mm und eine Wasserdampfübertragungsrate von weniger als 10⁻⁵ g/m²/Tag/atm/0,1 mm aufweist.

6. Organischer Dünnfilmtransistor (10) nach einem der Ansprüche 1 und 2 bis 5, **dadurch gekennzeichnet, dass** der Zwischenschichtisolierfilm (17) mindestens eines von Polyvinylalkoholharz, Polyvinylacetalharz, Acrylharz, Ethylcelluloseharz, Polyethylen, Polystyrol, Polyamid, das in mindestens einem von Ethylenglycolbutylether, Ethylenglycolhexylether, Dipropylenglycolbutylether, Dipropylenglycolmethyletheracetat, Tripropylenglycolmethylether, Diethylenglycolbutylether, α-Terpineol, Ethylenalkohol, Isopropylalkohol, 2,2,4-Timethyl-1 und 3-Pentanediolmonoisobutylat löslich ist, enthält, sodass das Lösungsmittel die organische Halbleiterschicht nicht löst oder anschwellt.

7. Herstellungsverfahren des organischen Dünnfilmtransistors (10) nach einem der Ansprüche 1 bis 6, wobei das Verfahren durch Folgendes gekennzeichnet ist:
einen Schritt eines Bildens der Gate-Elektrode (12) auf dem Substrat (11);
einen Schritt eines Bildens des Gate-Isolierfilms (13) auf der Gate-Elektrode (12);
einen Schritt eines Bildens der Source-Elektrode (14) und der Drain-Elektrode (15) mit dem Spalt dazwischen mindestens über der Gate-Elektrode (12), auf der der Gate-Isolierfilm (13) gebildet ist;
einen Schritt eines Bildens eines ersten Abschnitts (17a) des Zwischenschichtisolierfilms (17) auf dem Substrat (11), auf dem die Source-Elektrode (14) und die Drain-Elektrode (15) gebildet sind;
einen Schritt eines Bildens der organischen Halbleiterschicht (16) in Kontakt mit dem ersten Abschnitt (17a) des Zwischenschichtisolierfilms (17) in einem Bereich, der den Spalt enthält; und
einen Schritt eines Bildens eines zweiten Abschnitts (17b) des Zwischenschichtisolierfilms (17) mindestens über der organischen Halbleiterschicht (16),
**dadurch gekennzeichnet, dass** die organische Halbleiterschicht (16) ein organisches Halbleitermaterial umfasst, das in einem organischen Lösungsmittel löslich ist, und ein polymeres Material mit einer Triarylamin-Struktur ist.

8. Herstellungsverfahren des organischen Dünnfilmtransistors (10) nach Anspruch 7, **dadurch gekennzeichnet, dass** der erste Abschnitt (17a) des Zwischenschichtisolierfilms (17) in einer Gitterform oder in einer Form von Linien gebildet ist.

9. Herstellungsverfahren des organischen Dünnfilmtransistors (10) nach Anspruch 7, **dadurch gekennzeichnet, dass** ein Bilden der organischen Halbleiterschicht (16) ein Drucken der organischen Halbleiterschicht (16) umfasst.

10. Herstellungsverfahren des organischen Dünnfilmtransistors (10) nach Anspruch 7, **dadurch gekennzeichnet, dass** ein Bilden der organischen Halbleiterschicht (16) ein Tintenstrahldrucken der organischen Halbleiterschicht (16) umfasst.

11. Herstellungsverfahren des organischen Dünnfilmtransistors (10) nach Anspruch 7, **dadurch gekennzeichnet, dass** ein Bilden des ersten (17a) und zweiten (17b) Abschnitts des Zwischenschichtisolierfilms (17) ein Drucken des Zwischenschichtisolierfilms (17) umfasst.

12. Herstellungsverfahren des organischen Dünnfilmtransistors (10) nach Anspruch 7, **dadurch gekennzeichnet, dass** ein Bilden des ersten (17a) und zweiten (17b) Abschnitts des Zwischenschichtisolierfilms (17) ein Siebdrucken des Zwischenschichtisolierfilms (17) umfasst.

13. Organische Dünnfilmtransistoranordnung, **gekennzeichnet durch**:
den organischen Dünnfilmtransistor (10) nach einem der Ansprüche 1 bis 6.

## Revendications

1. Transistor à film mince organique (10), comprenant :
une électrode grille (12) formée sur un substrat (11) ;
un film d'isolation de grille (13) formé sur l'électrode grille (12) ;
une électrode source (14) et une électrode drain (15) formées, avec un espace entre celles-ci, au moins sur l'électrode grille (12) sur laquelle le film d'isolation de grille (13) est formé ;
une couche de semi-conducteur organique (16) formée dans une région incluant l'espace ;
un film d'isolation intercouche (17) ayant une première portion (17a) formée pour être partiellement couverte par une partie de la couche de semi-conducteur organique (16) et ayant une seconde portion (17b) formée pour couvrir la couche de semi-conducteur organique (16) ; et
une couche conductrice (18) formée sur le film d'isolation intercouche (17) et connectée à l'électrode drain (15) ;
**caractérisé en ce que**
la couche de semi-conducteur organique (16) comprend un matériau semi-conducteur organique soluble dans un solvant organique, ladite couche de semi-conducteur organique (16) étant un matériau polymérique ayant une structure triarylamine.

2. Transistor à film mince organique (10) selon la revendication 1, **caractérisé en ce que** le film d'isolation intercouche (17) contient une résine liante et des particules.

3. Transistor à film mince organique (10) selon l'une quelconque des revendications 1 ou 2, **caractérisé en ce que** le film d'isolation intercouche (17) inclut un matériau qui comprend au moins un de : oxyde de métal, hydroxyde de métal, complexe de métal, particules colorées - en particulier noir de carbone, pigment azoïque, pigment à base de phtalocyanine, pigment à base de pérylène et colorant - en particulier pigments noir, indigo et blanc d'aniline incluant de l'oxyde de titane et de l'oxyde de zinc, de telle sorte que la couche d'isolation intercouche soit capable de bloquer de la lumière de 600 nm ou moins.

4. Transistor à film mince organique (10) selon la revendication 3, **caractérisé en ce que** la couche de semi-conducteur organique (16) absorbe de la lumière avec une longueur d'onde de 600 nm ou moins.

5. Transistor à film mince organique (10) selon l'une quelconque des revendications 1 et 2 à 4, **caractérisé en ce que** le film d'isolation intercouche (17) inclut un matériau qui comprend au moins un de : oxyde de métal, hydroxyde de métal, complexe de métal, particules colorées - en particulier noir de carbone, pigment azoïque, pigment à base de phtalocyanine, pigment à base de pérylène et colorant - en particulier pigments noir, indigo et blanc d'aniline incluant de l'oxyde de titane et de l'oxyde de zinc et a un taux de transmission d'oxygène inférieur à 10⁻² cc/m²/jour/atm/0,1 mm et un taux de transmission de vapeur d'eau inférieur à 10⁻⁵ g/m²/jour/atm/0,1 mm.

6. Transistor à film mince organique (10) selon l'une quelconque des revendications 1 et 2 à 5, **caractérisé en ce que** le film d'isolation intercouche (17) contient au moins un de : résine d'alcool polyvinylique, résine d'acétal polyvinylique, résine acrylique, résine d'éthylcellulose, polyéthylène, polystyrène, polyamide soluble dans au moins un de : éther butylique d'éthylèneglycol, éther hexylique d'éthylèneglycol, éther butylique de dipropylèneglycol, acétate d'éther méthylique de dipropylèneglycol, éther méthylique de tripropylèneglycol, éther butylique de diéthylèneglycol, α-terpinéol, alcool éthylénique, alcool isopropylique, 2,2,4-triméthyl-1 et monoisobutylate de 3-pentanediol, de telle sorte que le solvant ne dissolve pas ou ne gonfle pas la couche de semi-conducteur organique.

7. Procédé de fabrication du transistor à film mince organique (10) selon l'une quelconque des revendications 1 à 6, le procédé étant **caractérisé par** :
une étape de la formation de l'électrode grille (12) sur le substrat (11) ;
une étape de la formation du film d'isolation de grille (13) sur l'électrode grille (12) ;
une étape de la formation de l'électrode source (14) et de l'électrode drain (15), avec l'espace entre celles-ci, au moins sur l'électrode grille (12) sur laquelle le film d'isolation de grille (13) est formé ;
une étape de la formation d'une première portion (17a) du film d'isolation intercouche (17) sur le substrat (11) sur lequel l'électrode source (14) et l'électrode drain (15) sont formées ;
une étape de la formation de la couche de semi-conducteur organique (16) en contact avec la première portion (17a) du film d'isolation intercouche (17) dans une région incluant l'espace ; et
une étape de la formation d'une seconde portion (17b) du film d'isolation intercouche (17) au moins sur la couche de semi-conducteur organique (16),
**caractérisé en ce que** la couche de semi-conducteur organique (16) comprend et matériau semi-conducteur organique soluble dans un solvant organique est un matériau polymérique ayant une structure triarylamine.

8. Procédé de fabrication du transistor à film mince organique (10) selon la revendication 7, **caractérisé en ce que** la première portion (17a) du film d'isolation intercouche (17) est en forme de treillis ou en forme de lignes.

9. Procédé de fabrication du transistor à film mince organique (10) selon la revendication 7, **caractérisé en ce que** la formation de la couche de semi-conducteur organique (16) comprend l'impression de la couche de semi-conducteur organique (16).

10. Procédé de fabrication du transistor à film mince organique (10) selon la revendication 7, **caractérisé en ce que** la formation de la couche de semi-conducteur organique (16) comprend l'impression à jet d'encre de la couche de semi-conducteur organique (16).

11. Procédé de fabrication du transistor à film mince organique (10) selon la revendication 7, **caractérisé en ce que** la formation des première (17a) et seconde (17b) portions des films d'isolation intercouche (17) comprend l'impression du film d'isolation intercouche (17).

12. Procédé de fabrication du transistor à film mince organique (10) selon la revendication 7, **caractérisé en ce que** la formation des première (17a) et seconde (17b) portions du film d'isolation intercouche (17) comprend l'impression par écran du film d'isolation intercouche (17).

13. Réseau de transistors à film mince organique, **caractérisé par** :
le transistor à film mince organique (10) de l'une quelconque des revendications 1 à 6.
